# EUROPEAN PATENT APPLICATION

(11) **EP 4 693 357 A1**
(43) Date of publication of application: **11.02.2026**
(21) Application number: 25306278.0
(22) Date of filing: 04.08.2025
(51) Int. Cl.: H01H 9/52, H01H 71/12, H05K 1/02, H02B 1/56, H01H 9/54

(54) **CIRCUIT BREAKER FOR ELECTRICAL DEVICE AND ELECTRICAL SYSTEM**

(30) Priority: 09.08.2024 CN 202421939887 U
(71) Applicant: SCHNEIDER ELECTRIC INDUSTRIES SAS, 92500 Rueil-Malmaison (FR)
(72) Inventor: GONG, Zhenyao, Xi'an City, Shaanxi Province (CN); XIA, Xuedong, Shanghai, 201203 (CN); HE, Xiatian, Shanghai, 201203 (CN)
(74) Representative: Manitz Finsterwald Patent- und Rechtsanwaltspartnerschaft mbB

(57) **Abstract**

A circuit breaker for an electrical device and an electrical system are provided. The circuit breaker includes a housing, at least one first busbar, at least one second busbar, a circuit board, and an actuating mechanism. The first busbar is coupled to a power supply side of the circuit breaker. The second busbar is coupled to a load side of the circuit breaker. The circuit board is arranged between the at least one first busbar and the at least one second busbar and includes an electrical component, two ends of the electrical component are respectively coupled to the first busbar and the second busbar, and the electrical component is adapted to act during occurrence of a line abnormality to cut off the electrical connection between the first busbar and the second busbar. The actuating mechanism is arranged between the first busbar and the power supply side of the circuit breaker.

## Description

### FIELD

Example embodiments of the present disclosure generally relate to the field of electrical device, and in particular, to a circuit breaker for an electrical device and an electrical system.

### BACKGROUND

A circuit breaker is a protection device capable of quickly and accurately cutting off current, its stability and accuracy play a vital role in a power system. With the increasing complexity and diversity of power systems and electronic devices, the type and power consumption of electrical devices are also increasing, which puts forward higher requirements on the performance of circuit breakers.

### SUMMARY

In a first aspect of the present disclosure, a circuit breaker for an electrical device is provided. The circuit breaker includes: a housing; at least one first busbar arranged within the housing and coupled to a power supply side of the circuit breaker; at least one second busbar arranged within the housing, coupled to a load side of the circuit breaker, and spaced apart from the first busbar by a predetermined distance to establish insulation isolation between the first busbar and the second busbar; a circuit board arranged between the at least one first busbar and the at least one second busbar, and including: at least one electrical component, two ends of each of the at least one electrical component being coupled to the first busbar and the second busbar, respectively, to establish an electrical connection between the first busbar and the second busbar, and adapted to act during occurrence of a line abnormality to cut off the electrical connection between the first busbar and the second busbar; and an actuating mechanism arranged between the first busbar and the power supply side of the circuit breaker, and adapted to move from a closed position to an open position after the electrical connection between the first busbar and the second busbar is cut off, so as to disconnect a line where the electrical device is located.

In some embodiments, the circuit breaker further includes: a panel coupled to the housing and adapted to at least partially shield the actuating mechanism, the first busbar, the second busbar, and the circuit board.

In some embodiments, the circuit breaker further includes: an inlet terminal arranged on the housing and adapted to pass through the housing to be coupled to an inlet end of the actuating mechanism.

In some embodiments, the circuit breaker further includes: an outlet terminal arranged on the housing and adapted to pass through the housing to be coupled to the second busbar.

In some embodiments, the actuating mechanism further includes: an actuating handle adapted to pass through the panel and at least partially exposed on a side of the panel facing away from the housing.

In some embodiments, the circuit breaker further includes: a heat dissipation assembly coupled to at least one of the first busbar and the second busbar and adapted to dissipate heat from the electrical component via at least one of the first busbar and the second busbar.

In some embodiments, the heat dissipation assembly includes: a contact plate coupled to at least one of the first busbar and the second busbar; a heat pipe coupled to the contact plate and adapted to extend in a first direction; and a plurality of heat dissipation fins coupled to the heat pipe at intervals along the first direction.

In some embodiments, the electrical component includes a metal oxide semiconductor field effect transistor (MOSFET).

By arranging a first busbar and a second busbar at two ends of an electrical component respectively, if an abnormality occurs in a line (for example, a short-circuit current occurs in the line), the electrical component can cut off the connection between the first busbar and the second busbar. After the abnormality of the line disappears (for example, the short-circuit current disappears due to the disconnection between the first busbar and the second busbar), an actuating mechanism may be controlled to perform a breaking action to cut off the electrical connection between the first busbar and an inlet terminal. Therefore, a response speed of the circuit breaker can be improved by breaking the line through the electrical component, the generation of an arc is reduced during the breaking action is performed by the actuating mechanism, the safety of the line can be improved, and the service life of the circuit breaker is prolonged. In addition, two ends of the electrical component are respectively coupled to the first busbar and the second busbar, which is beneficial to heat dissipation of the electrical component. The stability of the circuit breaker during a long-time and large-current operation is improved.

In a second aspect of the present disclosure, an electrical system is provided. The electrical system includes: an electrical device; and the circuit breaker provided in the first aspect of the present disclosure and coupled to the electrical device.

It should be understood that content described in this content section is not intended to limit key features or important features of embodiments of the present disclosure, nor is it intended to limit the scope of the present disclosure. Other features of the present disclosure will be readily understood from the following description.

### BRIEF DESCRIPTION OF DRAWINGS

The above and other features, advantages, and aspects of embodiments of the present disclosure will become more apparent with reference to the following detailed description taken in conjunction with the accompanying drawings. In the drawings, the same or similar reference numbers refer to the same or similar elements, wherein:
FIG. 1 shows a schematic diagram of an electrical system according to some embodiments of the present disclosure;
FIG. 2 shows a schematic diagram of an overall structure of a circuit breaker according to some embodiments of the present disclosure;
FIG. 3 shows a schematic diagram of an internal structure of a circuit breaker according to some embodiments of the present disclosure; and
FIG. 4 shows a schematic diagram of an internal structure of a circuit breaker from other perspectives according to some embodiments of the present disclosure.

### DETAILED DESCRIPTION

Embodiments of the present disclosure will be described in more detail below with reference to the accompanying drawings. While certain embodiments of the disclosure are illustrated in the drawings, it should be understood that the disclosure may be embodied in various forms and should not be construed as limited to the embodiments set forth herein, but rather, these embodiments are provided to provide a more thorough and complete understanding of the disclosure. It should be understood that the drawings and embodiments of the present disclosure are only used for example, and are not intended to limit the protection scope of the present disclosure.

It should be noted that the titles of any of the sections/subsections provided herein are not limiting. Various embodiments are described herein throughout, and any type of embodiment may be included under any section/subsection. Furthermore, embodiments described in any section/subsection may be combined in any manner with any other embodiments described in the same section/subsection and/or different sections/subsections.

In the description of embodiments of the present disclosure, the term "including" and similar terms thereof should be understood as open-ended inclusion, that is, "including but not limited to". The term "based on" should be understood to be "based at least in part on". The terms "an embodiment" or "the embodiment" should be understood as "at least one embodiment". The term "some embodiments" should be understood as "at least some embodiments". Other explicit and implicit definitions may also be included below. The terms "first", "second", etc. may refer to different or identical objects. Other explicit and implicit definitions may also be included below.

As mentioned briefly above, the conventional circuit breaker drives a moving contact to make contact with and separate from a static contact through a swing of an actuating mechanism between a closed position and an open position, so as to control the connection/disconnection of the line. However, the conventional circuit breaker has a slow breaking speed when breaking a line with large current, and an arc is easily generated, thereby bringing about potential safety hazards. In addition, arc generated during breaking can also affect the service life of the circuit breaker.

In order to solve or at least partially solve the above problems or other potential problems existing in the conventional technology, embodiments of the present disclosure provide a circuit breaker for an electrical device and an electrical system. By arranging a first busbar and a second busbar at two ends of an electrical component respectively, if an abnormality occurs in a line (for example, a short-circuit current occurs in the line), the electrical component can cut off the connection between the first busbar and the second busbar. After the abnormality of the line disappears (for example, the short-circuit current disappears due to the disconnection between the first busbar and the second busbar), an actuating mechanism may be controlled to perform a breaking action to cut off the electrical connection between the first busbar and an inlet terminal. Therefore, a response speed of the circuit breaker can be improved by breaking the line through the electrical component, the generation of an arc is reduced during the breaking action is performed by the actuating mechanism, the safety of the line can be improved, and the service life of the circuit breaker is prolonged. In addition, two ends of the electrical component are respectively coupled to the first busbar and the second busbar, which is beneficial to heat dissipation of the electrical component. The stability of the circuit breaker during a long-time and large-current operation is improved.

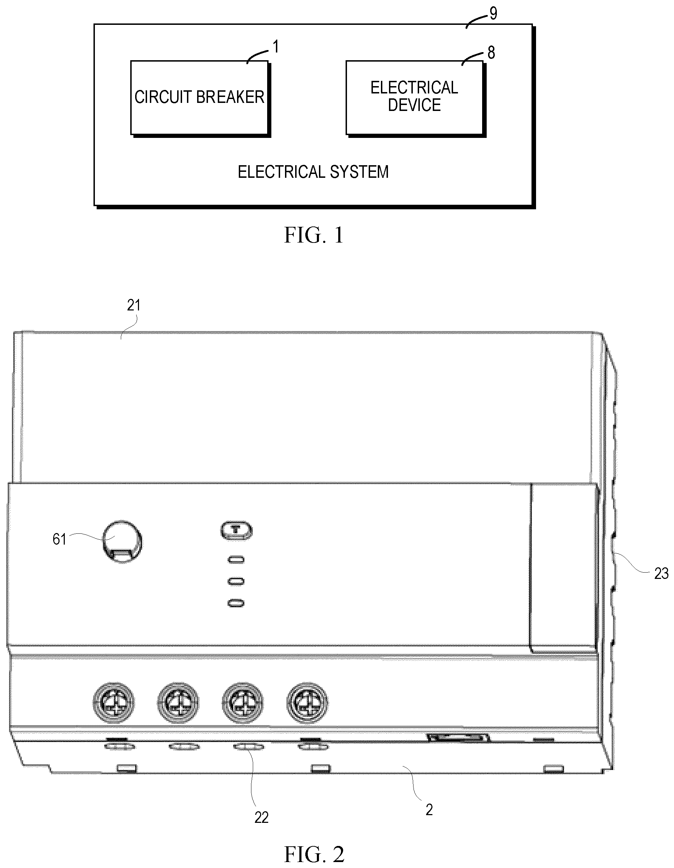

FIG. 1 shows a schematic diagram of an electrical system according to some embodiments of the present disclosure. As shown in FIG. 1, the electrical system 9 generally includes a circuit breaker 1 and an electrical device 8, a power supply side of the circuit breaker 1 is coupled to a power supply, and a load side of the circuit breaker 1 is coupled to the electrical device 8, so that the circuit breaker 1 can protect the electrical safety of the electrical device 8 by controlling connection/disconnection of a line between the electrical device 8 and the power supply.

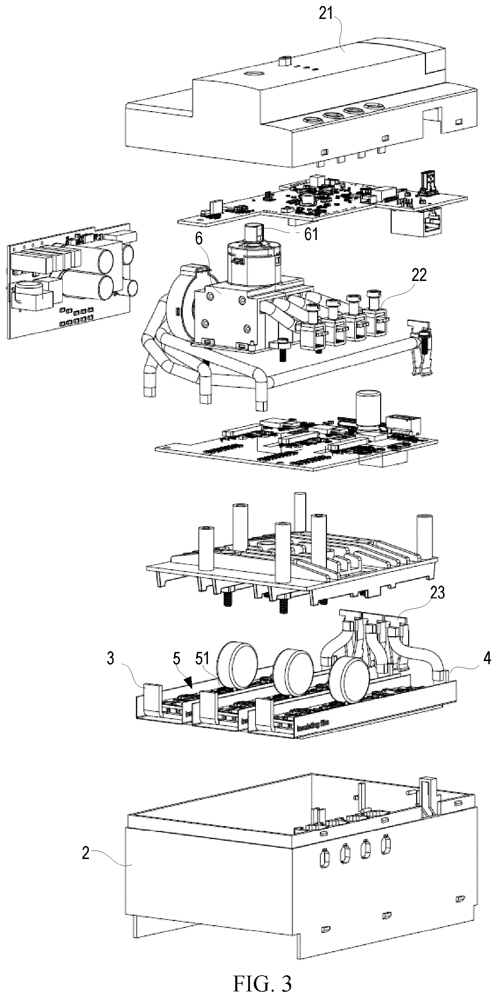

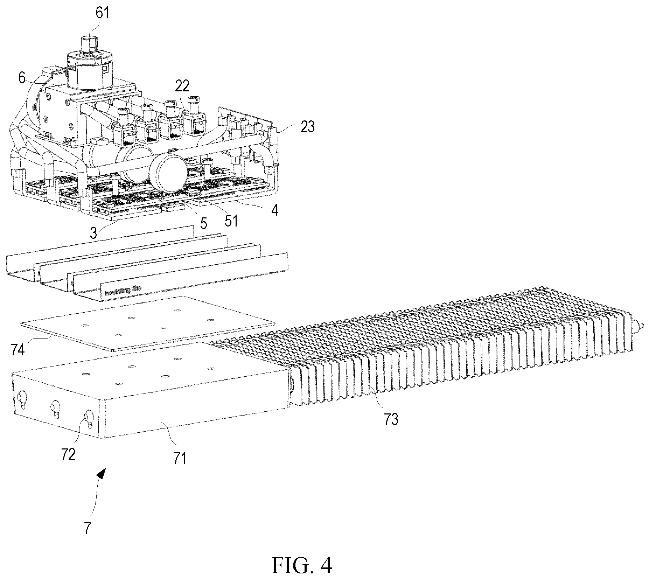

FIG. 2 shows a schematic diagram of an overall structure of a circuit breaker according to some embodiments of the present disclosure, and FIG. 3 and FIG. 4 respectively show schematic diagrams of internal structures of the circuit breaker according to some embodiments of the present disclosure. As shown in FIGS. 2-4, the circuit breaker 1 includes a housing 2, at least one first busbar 3 fixed to the housing 2, and at least one second busbar 4 fixed to the housing 2 and corresponding to the at least one first busbar 3. Each of the first busbar 3 is spaced apart from the second busbar 4 corresponding to the first busbar 3 by a predetermined distance, so that insulation isolation is established between the first busbar 3 and the second busbar. A circuit board 5 is further arranged between the first busbar 3 and the second busbar 4, at least one electrical component 51 is coupled to the circuit board 5, and the number of the electrical components 51 corresponds to the number of the at least one first busbar 3 and/or the at least one second busbar 4. Two ends of the electrical component 51 are respectively connected to the corresponding first busbar 3 and the corresponding second busbar 4. Thus, the first busbar 3 may connected to or disconnected from the second busbar 4 through the electrical component 51.

In some embodiments, an electrical parameter sensor and a micro control unit are coupled to the circuit board. The electrical parameter sensor is suitable for detecting electrical signals in the line and sending the electrical signals to the micro control unit, and the micro control unit can determine the state of the line according to the electrical signals obtained by the electrical parameter sensor. If the micro control unit determines that an abnormality occurs in the line, for example, a short-circuit current occurs in the line, the micro control unit may control the electrical component 51 to operate, so as to disconnect the electrical connection between the first busbar 3 and the second busbar 4.

In some embodiments, the electrical component 51 may include a metal oxide semiconductor field effect transistor (MOSFET). a source electrode and a drain electrode of the MOSFET is coupled to the first busbar 3 and the second busbar 4, respectively, and a gate electrode is coupled to the micro control unit. If the micro control unit determines an electrical abnormality, the micro control unit sends a control signal (for example, a high level signal) to the gate electrode, thereby disconnecting the connection between the source electrode and the drain electrode (that is, cutting off the electrical connection between the first busbar 3 and the second busbar 4).

As shown in FIG. 3 and FIG. 4, an actuating mechanism 6 is also fixed on the housing 2, and the actuating mechanism 6 is arranged between the first busbar 3 and the power supply side of the circuit breaker 1. The actuating mechanism 6 includes an inlet end coupled to the power supply side of the circuit breaker 1 and an outlet end coupled to the first busbar 3. If an electrical abnormality occurs in the line (for example, a short-circuit current occurs in the line), first, the electrical component 51 acts and cuts off the electrical connection between the first busbar 3 and the second busbar 4, and then after the short-circuit current disappears, the actuating mechanism 6 acts (i.e., trips) and cuts off the electrical connection between the first busbar 3 and the power supply side of the circuit breaker 1. Therefore, the actuating mechanism 6 can further improve the safety of the circuit breaker 1 during breaking and facilitate maintenance of the line and the circuit breaker 1 by operation and maintenance personnel. When the actuating mechanism 6 trips, the abnormal current in the line disappears, so that the action of the circuit breaker 1 does not generate an arc, thereby improving the safety of the operation of the circuit breaker 1 and prolonging the service life of the circuit breaker 1.

In some embodiments, the actuating mechanism 6 further includes an actuating handle 61, and the actuating handle 61 is adapted to drive the moving contact to move to make contact with or separate from the static contact. For example, the operation and maintenance personnel may use the actuating handle 61 to reset the circuit breaker 1 after the circuit breaker 1 is tripped.

In some embodiments, the power supply side of the circuit breaker 1 may include an inlet terminal 22, the inlet terminal 22 passes through the housing 2, and the inlet terminal 22 is coupled to the inlet end of the actuating mechanism 6. In some embodiments, the power supply side of the circuit breaker 1 may include a plurality of inlet terminals 22, for example, the power supply side of the circuit breaker 1 may include four inlet terminals 22, and the four inlet terminals 22 respectively correspond to three-phase live wires and one neutral wire.

In some embodiments, the load side of the circuit breaker 1 may include an outlet terminal 23 arranged on the housing 2 and coupled to the second busbar 4. Similar to the inlet terminals 22, the load side of the circuit breaker 1 may also include a plurality of outlet terminals 23. For example, the load side of the circuit breaker 1 may include four outlet terminals 23, and the four outlet terminals 23 respectively correspond to three-phase live wires and one neutral wire of the electrical device.

In some embodiments, the circuit breaker 1 may include three first busbars 3 and three second busbars 4. The three first busbars 3 are sequentially arranged along a mounting direction perpendicular to an extending direction, and a predetermined interval is left between two adjacent first busbars 3, so that insulation isolation is maintained between the three first busbars 3. The three first busbars 3 are respectively coupled to the outlet ends of the actuating mechanism 6, so that the three first busbars 3 can be respectively connected to three-phase live wires of the line. The three second busbars 4 are arranged at one end of the three first busbars 3 in the extending direction, and the three second busbars 4 are respectively aligned with the three first busbars 3 in the extending direction. A predetermined interval is left between two adjacent second busbars 4 of the three second busbars 4, so that insulation isolation is maintained between the three second busbars 4. The three second busbars 4 are respectively coupled to the three outlet terminals 23 to correspond to the three-phase live wires in the line (the inlet terminal 22 corresponding to the neutral wire may be connected to the outlet terminal 23 via the actuating mechanism 6). The circuit board 5 mentioned above may be integrally coupled to the three first busbars 3 and the three second busbars 4. The circuit board 5 may also be divided into three separate sections each coupled to the corresponding first busbar 3 and the corresponding second busbar 4.

Referring back to FIG. 2, in some embodiments, the housing 2 further includes a panel 21 coupled to the housing 2 and adapted to at least partially shield the first busbar 3, the second busbar 4, the actuating mechanism 6, and the circuit board. Therefore, stable operation of the internal mechanism of the circuit breaker 1 is ensured.

In some embodiments, the actuating terminal 61 of the circuit breaker 1 is adapted to pass through the panel 21 and is at least partially exposed on a side of the panel 21 facing away from the housing 2 (i.e., a side of the panel 21 facing the user), thereby facilitating user's operation of the actuating handle 61.

In some embodiments, the circuit breaker 1 further includes a heat dissipation assembly 7 including a contact plate 71, a heat pipe 72 coupled to the contact plate 71, and a plurality of heat dissipation fins 73 coupled to the heat pipe 72. The contact plate 71 is coupled to at least one of the first busbar 3 and the second busbar 4. In some embodiments, the contact plate 71 and the housing 2 may be coupled to the first busbar 3 and the second busbar 4 at same time, and the contact plate 71 is isolated from the first busbar 3 and the second busbar 4 by an isolation pad 74. The isolation pad 74 is made of an insulating and thermally conductive material, so that the isolation pad 74 can conduct heat of the first busbar 3 and the second busbar 4 while providing insulation protection for the first busbar 3 and the second busbar 4.

The heat pipe 72 partially passes through an internal of the contact plate 71, and a part of the heat pipe 72 arranged outside of the contact plate 71 extends in a first direction. The plurality of heat dissipation fins 73 are parallel to each other and coupled to the heat pipe 72 in the first direction, and adjacent heat dissipation fins 73 are arranged at intervals. In this way, during operation of the circuit breaker 1, the heat generated by the electrical component 51 may be conducted to the contact plate 71 through the first busbar 3 and/or the second busbar 4, and is conducted to the heat dissipation fin 73 through the heat pipe 72 for heat dissipation. Thus, the operating temperature of the circuit breaker 1 is reduced, the safety of the operation of the circuit breaker 1 is provided, and the service life of the circuit breaker 1 is prolonged.

Embodiments of the present disclosure have been described above, and the above description is illustrative, not exhaustive, and is not limited to the disclosed embodiments. Many modifications and variations will be apparent to those of ordinary skill in the art without departing from the scope and spirit of the illustrated embodiments. The selection of terms as used herein is intended to best explain the principles of the embodiments, the practical application or technical improvements to the market, or to enable others of ordinary skill in the art to understand the embodiments disclosed herein.

## Claims

1. A circuit breaker for an electrical device, **characterized by** comprising:
a housing (2);
at least one first busbar (3) arranged within the housing (2) and coupled to a power supply side of the circuit breaker (1);
at least one second busbar (4) arranged within the housing (2), coupled to a load side of the circuit breaker (1), and spaced apart from the first busbar (3) by a predetermined distance to establish insulation isolation between the first busbar (3) and the second busbar (4);
a circuit board (5) arranged between the at least one first busbar (3) and the at least one second busbar (4), and comprising: at least one electrical component (51), two ends of each of the at least one electrical component (51) being coupled to the first busbar (3) and the second busbar (4), respectively, to establish an electrical connection between the first busbar (3) and the second busbar (4), and adapted to act during occurrence of a line abnormality to cut off the electrical connection between the first busbar (3) and the second busbar (4); and
an actuating mechanism (6) arranged between the first busbar (3) and the power supply side of the circuit breaker (1), and adapted to move from a closed position to an open position after the electrical connection between the first busbar (3) and the second busbar (4) is cut off, so as to disconnect a line where the electrical device (8) is located.

2. The circuit breaker of claim 1, **characterized by** further comprising:
a panel (21) coupled to the housing (2) and adapted to at least partially shield the actuating mechanism (6), the first busbar (3), the second busbar (4), and the circuit board (5).

3. The circuit breaker of claim 1 or 2, **characterized by** further comprising:
an inlet terminal (22) arranged on the housing (2) and adapted to pass through the housing (2) to be coupled to an inlet end of the actuating mechanism (6).

4. The circuit breaker of any of claims 1 to 3, **characterized by** further comprising:
an outlet terminal (23) arranged on the housing (2) and adapted to pass through the housing (2) to be coupled to the second busbar (4).

5. The circuit breaker of claim 2, **characterized in that** the actuating mechanism (6) further comprises:
an actuating handle (61) adapted to pass through the panel (21) and at least partially exposed on a side of the panel (21) facing away from the housing (2).

6. The circuit breaker of any of claims 1 to 5, **characterized by** further comprising:
a heat dissipation assembly (7) coupled to at least one of the first busbar (3) and the second busbar (4) and adapted to dissipate heat from the electrical component (51) via at least one of the first busbar (3) and the second busbar (4).

7. The circuit breaker of claim 6, **characterized in that** the heat dissipation assembly (7) comprises:
a contact plate (71) coupled to at least one of the first busbar (3) and the second busbar (4);
a heat pipe (72) coupled to the contact plate (71) and adapted to extend in a first direction; and
a plurality of heat dissipation fins (73) coupled to the heat pipe (72) at intervals along the first direction.

8. The circuit breaker of any of claims 1 to 7, **characterized in that** the electrical component (51) comprises a metal oxide semiconductor field effect transistor (MOSFET).

9. An electrical system, **characterized by** comprising:
an electrical device (8); and
the circuit breaker (1) of any of claims 1 to 8 coupled to the electrical device (8).
